# EUROPEAN PATENT APPLICATION

(11) **EP 1 172 848 A1**
(43) Date of publication of application: **16.01.2002**
(21) Application number: 00830492.5
(22) Date of filing: 14.07.2000
(51) Int. Cl.: H01L 21/762, H01L 21/822, H01L 27/02

(54) **Integrated semiconductor structure**

(71) Applicant: STMicroelectronics S.r.l., 20041 Agrate Brianza (Milano) (IT)
(72) Inventor: Erratico, Pietro, 20133 Milano (IT)
(74) Representative: Pezzoli, Ennio

(57) **Abstract**

Integrated structure 100 in a chip of semiconductor material comprising a substrate 101 having a first type of conductivity and an epitaxial layer 102 grown on said substrate and having a conductivity of the first type less than the conductivity of the substrate.

Moreover, the integrated structure comprises a first region 104 and a second region 105 included in the epitaxial layer and having a conductivity opposite to that of the layer, said first and said second regions extending from a surface 103' of the epitaxial layer opposite the substrate into the layer so as to form a first and a second junction with said layer, and means for reducing an injection of current through the layer from said first to said second region when the first junction is directly biased. The integrated structure is characterized by the fact that said means comprise an isolating element 107 located between said first and second regions and extending from said surface of the epitaxial layer substantially at least as far as the substrate.

## Description

The present invention relates to an integrated structure in a chip of a semiconductor material.

It is known to use particular integrated structures in chips of semiconductor material having a substrate which has a high concentration of impurities, i.e. with doping of the P+ type (or N+ type), and an epitaxial layer which has a conductivity of the same type as that of the substrate, but a low concentration of impurities, i.e. with doping of the P- type (or N- type). These structures are commonly called "P+P-" (or N+N-) structures. The epitaxial layer also has, formed in it, suitably doped regions inside which electronic components or circuit groups are formed.

The various known technologies relating to power applications include BCD (Bipolar, CMOS, DMOS) technology.

BCD technology is able to allow integration of several output power devices, being particularly advantageous when it is required to construct half-bridge or whole-bridge circuits both of the single-phase and three-phase type or when a large number of parallel outputs is required. The need, dictated by particular applications, to have several isolated outputs results in the use of a substrate having a polarity different from that of a collector of a bipolar transistor or from that of a drain of a MOS transistor, which are integrated in the epitaxial layer. Consequently, in BCD technology, the integrated components are provided with terminals which, in order to be isolated, are located on the surface of the semiconductor chip. In particular, in the context of BCD technology and for power applications where supply voltages which are not high - typically, but not exclusively ranging between 30 V and 60 V - are required, P+P- structures are used. In these cases, the P+P-structures used have a low thickness of the epitaxial layer ranging, for example, between 5 µm and 7 µm.

In general, the electronic components or the circuit groups formed in a general structure integrated in a chip of semiconductor material must be electrically isolated from each other.

An isolating technique which is widely used consists in creating, inside the chip of semiconductor material, isolating regions which have a conductivity of the type opposite to that of the semiconductor material. These isolating regions are biased with respect to the semiconductor material so that the PN junctions which they form with the material are reverse-biased. The reverse-biasing of these regions, containing various components or circuit groups, ensures that they are isolated under normal operating conditions.

It is known that, in integrated structures comprising two or more isolating regions or other regions with a conductivity of the type opposite to that of the semiconductor material inside which they are formed, undesired current flows which cause abnormal operation of the integrated structure may occur. These currents are caused by transient direct biasing of these junctions which, during normal operation, are reverse-biased.

For example, in the case of power applications of the integrated structure, this direct biasing may occur upon switching of polarity in inductive loads, such as inductances or motors, or in capacitive loads, such as capacitors, batteries and accumulators.

Moreover, this current generated by injection of charges from a region directly biased with respect to the semiconductor material in which it is formed, may reach a further region similar to said region, but reverse-biased. In this situation a parasitic bipolar transistor of the lateral type is formed, the two homologous regions forming the emitter and the collector and the intermediate semiconductor material forming the base thereof.

It is pointed out that the formation of parasitic transistors constitutes a particularly serious problem for technologies, such as BCD technology and CMOS technology, where several components each with an output designed to assume a different potential is formed on a single integrated circuit. Generally, these phenomena are also known by the term "latch-up".

Various techniques aimed at reducing the effects of formation of these lateral parasitic transistors are known.

According to a first technique, the two homologous regions are suitably spaced so as to reduce the gain of the parasitic transistor. This technique involves a considerable reduction in the area of the integrated structure which can be used for other circuit components.

According to a different technique, the portion of semiconductor material located between the two homologous regions, i.e. the base of the parasitic transistor, is doped more so as to reduce the gain of this transistor. This technique has the disadvantage that, in power applications, a strong electrical field may be created. In order to reduce the effect of this electrical field, it is necessary to form a suitable termination structure for the homologous regions with consequent considerable wastage of the chip area.

According to a further technique, an additional region having a conductivity opposite to that of the epitaxial layer is formed in the epitaxial layer and between the homologous regions. This additional region allows division of the parasitic component comprised between the homologous regions in two lateral parasitic transistors having a common base, formed by the substrate.

This intermediate region is electrically connected to the epitaxial layer by means of a superficial metal contact strip. This reduces locally the substrate potential, preventing bias conditions resulting in current injection from occurring. This technique requires a suitable termination structure which results in a considerable amount of space being used. Moreover, in the case of P+P- structures, it does not guarantee radical solutions since these structures, owing to the fact that the P+ substrate has a high conductivity, have a resistance towards the ground with a low value and this renders problematic the required reduction in the substrate potential.

The object of the present invention is to overcome the abovementioned drawbacks of the known art using a technical solution which is effective and is not difficult to apply. In order to achieve this object, the invention, as described in the claims, is proposed.

In fact, the present invention provides an integrated structure in a chip of semiconductor material comprising:
- a substrate with a first type of conductivity;
- an epitaxial layer grown on said substrate with a conductivity of the first type, the epitaxial layer having a conductivity which is less than the conductivity of the substrate;
- a first and a second region included in the epitaxial layer and having a conductivity opposite to that of the layer; said first and said second region extending from a surface of the epitaxial layer opposite the substrate into the layer so as to form a first and a second junction with said layer;
- means for reducing an injection of current through the layer from said first to said second region when the first junction is directly biased;
characterized in that said means comprise an isolating element which is located between said first and second region, extending from said surface of the epitaxial layer substantially at least as far as the substrate.

Moreover, the present invention relates to a method for producing an integrated structure.

Further characteristic features and advantages of the present invention will emerge from the following description below of preferred embodiments provided by way of a non-limiting example, with reference to the accompanying figures, in which:
- Figure 1 shows schematically a lateral section through a first embodiment of the invention;
- Figure 2a shows a plan view of a first embodiment of the invention;
- Figure 2b shows a plan view of a second embodiment of the invention;
- Figure 2c shows a plan view of a third embodiment of the invention;
- Figures 3a to 3d show a lateral section through the integrated structure according to Figure 2c, during different stages in a manufacturing process.

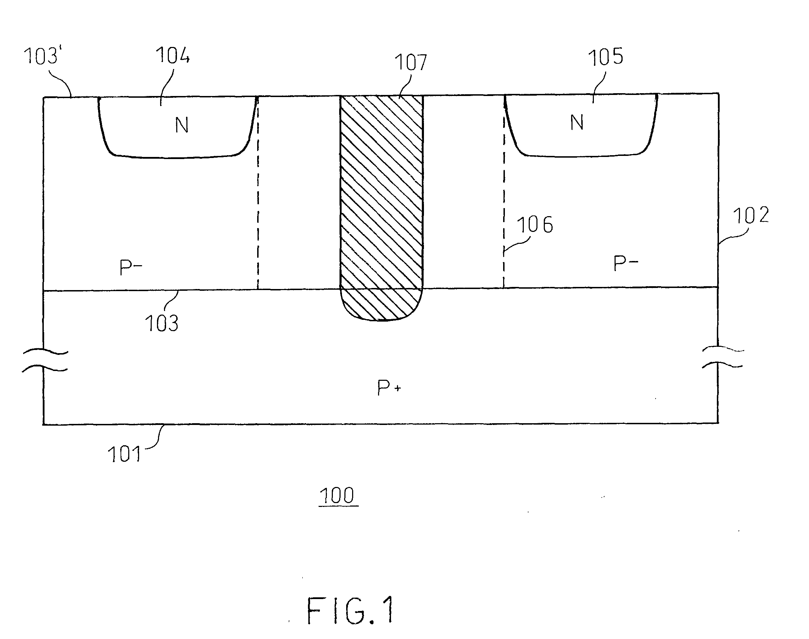

Figure 1 shows schematically a first embodiment of the integrated structure 100 provided in accordance with the invention;

The type (P or N) doping to which the present description refers are only examples and the person skilled in the art may easily adapt the teachings of the present inventions to structures using doping with signs opposite to those indicated.

The integrated structure 100 comprises a substrate 101, of the P type, in particular of the P+ type, and an epitaxial layer 102 which is grown above a boundary surface 103 of said substrate. The epitaxial layer 102 has a conductivity which is of the same type as that of the substrate 101, but has a smaller concentration of impurities. In particular, the epitaxial layer 102 is of the P- type.

For example, the substrate 101 of the P+ type is doped with impurities so as to have a resistivity of between 1 mΩ cm and 100 mΩ cm. Preferably, this conductivity ranges between 8 mΩ cm and 12 mΩ cm. The epitaxial layer 102 of the P- type is doped with impurities so as to have, for example, a resistivity of between 5 mΩ cm and 15 mΩ cm. Preferably, this resistivity is between 8 mΩ cm and 15 mΩ cm.

Moreover, the substrate 101, for example, has a thickness of between about 500-600 µm and the epitaxial layer 102 has a thickness of between about 5-15 µm. Preferably the epitaxial layer 102 has a thickness 102 of between 5-7 µm.

The epitaxial layer 102 has, formed in it, a region 104 of the N type and a region 105 of the N type. These regions extend from a surface 103' of the epitaxial layer 102, opposite the surface 103 of the substrate, into the epitaxial layer 105.

The integrated structure 100 may be advantageously used in the context of BCD (Bipolar-CMOS-DMOS) technology or in the context of CMOS technology.

In particular, the region 104 may be a base region of a bipolar transistor having the substrate 101 as the collector region and the region 105 may form the drain region of a DMOS (Double Diffused MOS) transistor.

The region 104 and the region 105 are separated by an interface region 106 forming part of the epitaxial layer 102.

The region 104 and the region 105 each form a PN junction with the epitaxial layer 102.

During normal operating conditions, two junctions are reverse-biased.

It should be noted that, in particular operating conditions, the PN junction and the interface layer 106 may produce an NPN parasitic lateral transistor. For example, the region 105 is suitable, if biased directly with respect to the epitaxial layer 102, for injecting electrons into this epitaxial layer. In other words, the PN junction formed by the region 105 and by the epitaxial layer 102 constitutes an emitter/base junction of a lateral parasitic transistor. The region 104, if reverse-biased with respect to the said epitaxial layer, is suitable for acting as a collector of this lateral parasitic transistor.

The interface region 106 contains an isolating element 107 which is located between the region 104 and the region 105 and extends from the surface 103' of the epitaxial layer 102 at least as far as the boundary surface 103 of the substrate 101. In particular, in Figure 1 the isolating element 107 extends partially inside the substrate 101.

The isolating element 107 allows the possibility of parasitic transistors being formed by the abovementioned sequence of differently doped regions, following particular bias conditions, to be reduced or eliminated.

During normal operation of the structure 100, the PN junctions between the regions 104 and 105 and the epitaxial layer 102 are reverse-biased, ensuring isolation between the two regions.

In a transient or abnormal bias situation, the region 105 may be at a negative potential with respect to that of the epitaxial layer 102 with the consequent injection of electrons into this layer.

The isolating element 107, owing to its isolating function, prevents the conduction of these electrons from the region 105 to the region 104 through the epitaxial layer 102.

In this way, the possibility of forming a lateral parasitic transistor in the structure 100 is substantially eliminated.

The electrons injected from the region 105 could reach the region 104 only by "bypassing" the isolating element 107 and passing through the substrate 101. It should be noted that a parasitic transistor of this type, i.e. having the substrate 101 as a base region, has a very low or substantially zero gain. The substrate 101, which is of the P+ type, has a high doping level and renders ineffective a transistor which comprises a portion of the said substrate in its base.

The parasitic transistors which are effective enough to cause operational disturbances of the integrated structure are those which have the base region immersed in the epitaxial layer 102, which has a concentration of impurities less than that of the substrate.

The isolating element 107, which extends substantially over the whole thickness of the epitaxial layer or also partially into the substrate, prevents the flow of current in the epitaxial layer and prevents the formation of the parasitic transistors.

It should be noted, moreover, that an isolating element with a thickness considerably less than the thickness of the epitaxial layer defines a conductive channel which is included in the epitaxial layer itself and which allows the electrons injected from the region 105 to reach the region 104, resulting in a parasitic transistor.

According to a preferred embodiment of the invention, this isolating element 107 comprises an isolating trench which extends from the surface 103', passing through the whole thickness of the epitaxial layer 102 as far as the boundary surface 103. Moreover, the trench 107 has oxidised walls and is filled with polysilicon (polycrystalline silicon).

The trench may extend, partially, also into the substrate 101.

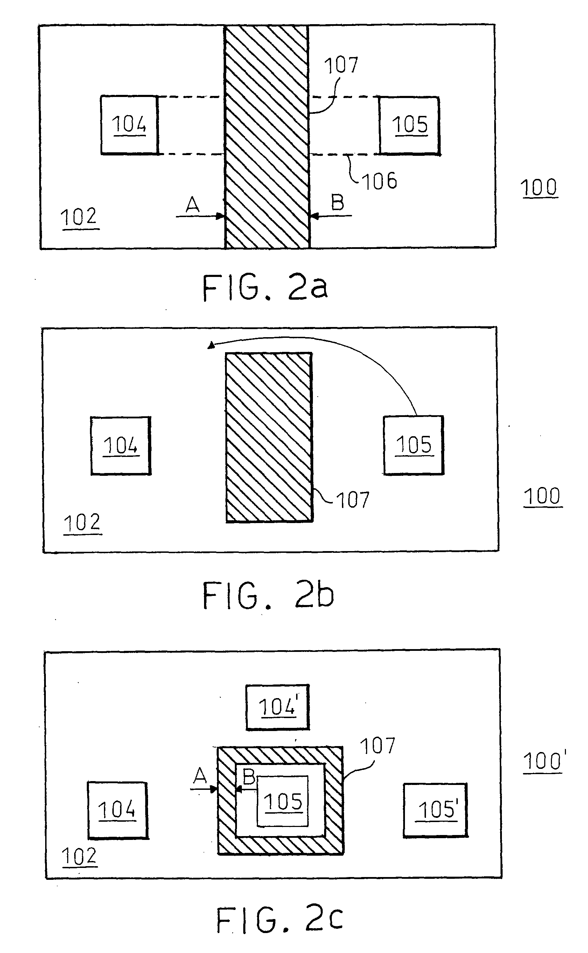

Figure 2a shows a plan view of the integrated structure 100. In the embodiment of the invention shown in Figure 2a, the isolating element 107 is located between the region 104 and the region 105 and extends over a length substantially equal to the width of the integrated circuit board 100 so as to divide the epitaxial layer 102 into two portions comprising, respectively, the region 104 and the region 105.

It should be noted that an effective reduction in the possibility of parasitic transistors being formed may also be obtained with an isolating element having a length less than the width of the integrated circuit board 100, as shown in Figure 2b. Such an isolating element 107 nevertheless has dimensions such as to render ineffective (i.e. provide with negligible gain) the lateral parasitic transistor comprising as a base a section of the epitaxial layer which extends along the sides of the said isolating element, i.e. corresponding to a path for the electrons of the type indicated by an arrow in Figure 2b.

Preferably, the isolating element 107 is formed at a distance from the two regions 104 and 105 so as to position it outside of the two drain regions associated with the two PN junctions which, under normal conditions, are reverse-biased. In this way, this isolating element is prevented from being subject to intense electrical fields which could damage it.

Moreover, with reference to Figures 2a and 2b, it should be noted that each of the two portions into which the epitaxial layer 102 is divided on account of the isolating element 107 may comprise several integrated circuit components, for example, corresponding respectively to a section for processing the signal and a power section.

Figure 2c shows an integrated structure on a chip 100' comprising, in addition to the isolating regions 104 and 105, also an isolating region 104' and an isolating region 105', both of the N type and relating to further circuit components (for example DMOS, CMOS transistors).

Advantageously, as shown in Figure 2c, the isolating element 107 may be formed so as to surround the region 105. In this way, both the possibility of lateral parasitic transistors being formed with the region 104, as well as the formation of these transistors with the regions of the N type 104' and 105' present on the chip 100', is avoided.

This result is particularly advantageous for integrated circuits formed in the context of BCD technology, where the same chip may include integrated circuit components having drain or collector terminals designed to assume different electric potentials. For example, these circuit components may form a conventional bridge structure for supplying inductive loads.

Typically, the isolating element 107 surrounds that region of the N type which is capable, owing to the particular circuital application of the component associated with it, of injecting electrons into the epitaxial layer 102, but nevertheless, this isolating element may be formed so as to surround those regions suitable for forming the collector of a possible parasitic transistor.

Moreover, the isolating element 107 may be formed so as to surround only partially a given isolating region, but in any case so as to render ineffective the lateral parasitic transistors which could be created.

The appropriate length of the isolating element 107, i.e. the value of the dimension A-B in Figures 2a and 2c, may be easily determined by the person skilled in the art on the basis of the present description and on the basis of the particular application of the integrated structure 100, in particular, taking into account the voltage supplying the said integrated structure.

For example, the isolating element 107 may comprise a trench having a length of about 1µ or a trench having a length equal to the length of the interface region 106.

It should be noted, for example, that the integrated structure according to Figures 1 and 2a-2c may be supplied with a voltage greater than 0 V and less than or equal to about 100 V and, preferably, between about 10 V and about 70 V. More preferably, this voltage may be between about 20 V and about 30 V.

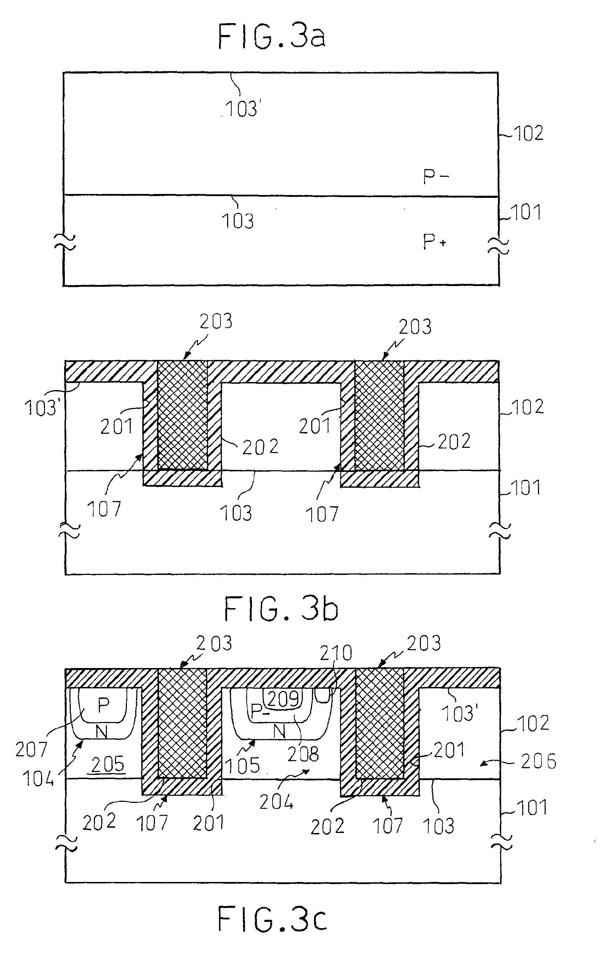

With reference to Figures 3a-3d, a method for forming, in accordance with the invention, a particular integrated structure such as the structure 100' comprising a bipolar transistor and a DMOS transistor will now be described. The elements similar to those described above will be indicated in the figures which follow by the same reference numbers.

In the description of this method of implementation, those steps which are known and obvious to a person skilled in the art will not be specifically described.

An epitaxial layer 102 of the P- type is grown on the surface of the silicon substrate 101, of the P+ type, as shown in Figure 3a.

Then a step involving formation of an isolating element similar to the isolating element 107 which surrounds the region 105 in Figure 2c is performed.

The step for creation of this isolating element involves formation of an isolating trench 201.

The trench is formed by means of anisotropic etching of the epitaxial layer 102. A suitable etching method is, for example, drying etching.

Figure 3b shows a cross-section through the integrated structure comprising the trench 201.

The walls of the trench 201 and the upper surface of the epitaxial layer 102 are covered by a layer 202 of insulating material such as, for example, silicon dioxide SiO₂.

Following this, the trench 201 is filled with dielectric material such as, for example, polysilicon 203 so as to make the upper surface of the said trench coplanar with the silicon dioxide layer 202 located on the upper surface of the epitaxial layer 102.

This allows the process for production of the integrated device to be performed using methods known in the art.

With reference to Figure 3c, the isolating trench 201 defines internally a region 204 included within the epitaxial layer 102 and two regions 205, 206 located outside the trench.

According to the particular embodiment of the invention described, a bipolar transistor is created in the region 205, while a DMOS transistor is created in the region 204.

Using known lithographic processes, two openings are created in the silicon dioxide layer 202 and through said openings diffusion of N-type impurities into the epitaxial layer 102 is performed. In this way the two regions 104 and 105 are created.

A region of the P type, 207, and a region of the P+ type, 208, are created by means of diffusion inside these two regions 104 and 105, respectively.

The regions 207, 104 and the assembly consisting of the underlying epitaxial layer 102 and substrate 101 constitute, respectively, the emitter, base and collector regions of a vertical bipolar transistor.

Two regions 209 and 210 of the N+ type are created by means of diffusion inside the region 208 and the region 105.

The region 209 and the region 208 are, respectively, the source region and body region of a DMOS transistor. The region 105 provided with the region 210, heavily doped, constitutes the collector (or drain) of this transistor. The region 210 prevents a PN junction being formed between the region 105 and the metal terminal which is made, for example, of aluminium and will be placed in electrical contact with this region 105.

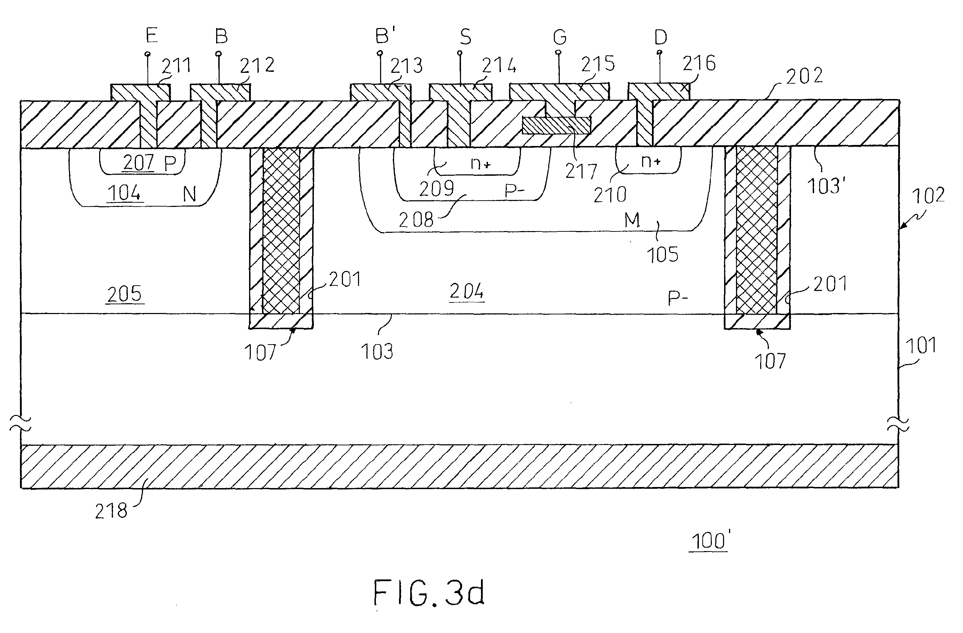

Figure 3d shows the integrated structure 100' provided with the metal electrodes of the emitter E 211 and the base B 212 of the bipolar transistor and with the metal electrodes of the body B' 213, source S 214, gate G 215 and drain D 216 of the DMOS transistor. The gate electrode G 215 comprises a polysilicon element 217 deposited, for example, using the known CVD (Chemical Vapour Deposition) technique. This gate electrode 217 is separated from the upper surface of the epitaxial layer 102 by a thin insulating layer.

Moreover, during a final step, a metal layer 118, for example made of aluminium, is formed, being arranged on the bottom surface of the substrate 101. This metal layer 218 acts as a collector electrode for the PNP bipolar transistor of the region 205.

The bipolar transistor formed in the region 205 according to Figure 3d may, for example, be a transistor for an analog (signal processing) part, while the DMOS transistor according to Figure 3d may be used as a power transistor suitable for supplying an inductive load (not shown) connected to its drain electrode D 216. This drain electrode may be in bias conditions which could result in the formation of an NPN parasitic transistor (comprising the region 104, the epitaxial layer 102 and the region 105) if the isolating element 107 were not present.

Moreover, a DMOS transistor may also be formed in the region 104 as occurs, for example, in the known DMOS bridge structures designed to supply inductive loads.

Circuit components other than those described such as, for example, integrated resistors or MOS transistors or NPN transistors may be associated with the region 104 and the region 105.

As is obvious to a person skilled in the art, the formation of the isolating element does not complicate significantly the method for construction of the integrated structure.

Alternatively, the step for formation of the isolating element may be performed following the steps for creation of the differently doped regions corresponding to the circuit components integrated in the single chip. In this case, the oxide layer present on the surface of the chip at the end of diffusion of the variously doped regions corresponding to the said integrated components will be removed so as to allow access to the epitaxial layer in which the trench will be formed. It should be noted that the step involving etching of the epitaxial layer may be advantageously performed at temperatures which are sufficiently low as not to alter substantially the configuration of the previously doped regions. However, the formation of the isolating element before the steps involving creation of the integrated devices is preferred because it avoids the said step involving removal of the isolating layer.

Obviously, a person skilled in the art, for the purpose of satisfying contingent and specific requirements, may make numerous modifications and variations to the integrated structure and to the production method described above, all of which, however, are contained within the scope of production of the invention, as defined in the following claims.

## Claims

1. Integrated structure (100; 100') in a chip of semiconductor material comprising:
- a substrate (101) with a first type of conductivity;
- an epitaxial layer (102) grown on said substrate and having a conductivity of the first type, the epitaxial layer having a conductivity less than the conductivity of the substrate;
- a first region (104) and a second region (105) included in the epitaxial layer and having a conductivity which is opposite to that of the layer; said first and said second regions extending from a surface of the epitaxial layer opposite the substrate into the layer so as to form a first and a second junction with said layer;
- means for reducing an injection of current through the layer from said first to said second region when the first junction is directly biased;
**characterized in that** said means comprise an isolating element (107) arranged between said first and said second region and extending from said surface of the epitaxial layer substantially at least as far as the substrate.

2. Integrated structure according to Claim 1, wherein said isolating element comprises a trench extending from said surface of the epitaxial layer as far as the substrate and filled with dielectric material.

3. Integrated structure according to Claim 1, wherein said isolating element is such as to surround partly said first region.

4. Integrated structure according to Claim 1, wherein said isolating element is such as to surround said second region.

5. Integrated structure according to Claim 1, wherein said isolating element has a length substantially equal to the width of said chip and divides the chip into two portions each including said first and said second regions.

6. Integrated structure according to Claim 2, wherein said trench includes polycrystalline silicon (203) for ensuring the planarity of the integrated structure.

7. Integrated structure according to Claim 1, wherein said substrate and said layer have a conductivity of the P type.

8. Integrated structure according to any one of Claims 1 to 7, wherein said first region comprises a power transistor (209, 208, 105) intended to control an inductive load having the collector region in said first region.

9. Method for the production of integrated structure comprising the steps of:
- providing a substrate having a first type of conductivity;
- growing on said substrate an epitaxial layer having a conductivity of the first type, said conductivity of the epitaxial layer being less than the conductivity of the substrate;
- forming, inside the substrate, a first and a second region having a conductivity opposite to that of the epitaxial layer; said first and second regions extending from a surface of said epitaxial layer opposite the substrate into the said epitaxial layer so as to form, together with the epitaxial layer, a first and a second junction;
- providing means for reducing an injection of current through the layer from said first to said second region when said first junction is directly biased;
**characterized in that** said step of providing means for reducing the injection of current comprises a step involving arrangement, between said first and second regions, of an isolating element extending from said surface of the epitaxial layer substantially at least as far as the substrate.

10. Method according to Claim 9, wherein said step of arranging an isolating element in between comprises a step involving formation of a trench extending from said surface of the epitaxial layer substantially at least as far as the substrate.

11. Method according to Claim 10, moreover comprising a step involving filling said trench with dielectric material.
